# EUROPÄISCHE PATENTSCHRIFT

(11) **EP 1 315 845 B1**
(45) Veröffentlichungstag und Bekanntmachung des Hinweises auf die Patenterteilung: **07.12.2005**
(21) Anmeldenummer: 01969272.2
(22) Anmeldetag: 08.09.2001
(51) Int. Cl.: C23C 14/58, H01J 9/22, C23C 14/06

(54) **VERFAHREN ZUR HERSTELLUNG EINER LEUCHTSTOFFSCHICHT**
METHOD FOR PRODUCING A COATING OF FLUORESCENT MATERIAL
PROCEDE POUR PRODUIRE UNE COUCHE DE MATIERE LUMINESCENTE

(30) Priorität: 08.09.2000 DE 10044425
(43) Veröffentlichungstag der Anmeldung: 04.06.2003
(73) Patentinhaber: AGFA-GEVAERT, 2640 Mortsel (BE)
(72) Erfinder: FUCHS, Manfred, 90459 Nürnberg (DE); HELL, Erich, 91054 Erlangen (DE); MATTERN, Detlef, 91056 Erlangen (DE); SCHMITT, Bernhard, 91052 Erlangen (DE)
(86) Internationale Anmeldenummer: PCT/DE2001/003435
(87) Internationale Veröffentlichungsnummer: WO 2002/020868

(56) Entgegenhaltungen:
- EP-A- 0 331 019
- DE-A- 2 832 141
- W. SCHUBERT: "PREPARATION OF SELF-SUPPORTING LARGE-AREA POLYCRYSTALLINE STRUCTURES OF CsI(Na) BY EVAPORATION." SIEMENS FORSCHUNGS- UND ENTWICKLUNGSBERICHTE, Bd. 3, Nr. 2, 1974, Seiten 100-102, XP002186654 DE

## Beschreibung

Die Erfindung betrifft ein Verfahren zur Herstellung einer Leuchtstoffschicht.

Aus der DE 195 16 450 C1 ist ein Verfahren zum Herstellen einer aus CsJ:Tl bestehenden Leuchtstoffschicht bekannt. Dabei ist vorgesehen, dass der Druck in der Bedampfungsanlage zumindest während des Bedampfens höher als der Dampfdruck des Thalliumjodids ist. Aus diesem Verfahren lässt sich eine Leuchtstoffschicht herstellen, deren Lichtausbeute verbessert ist.

Ein experimentelles Verfahren zum Herstellen einer aus CsJ(Na) bestehenden Leuchtstoffschicht ist auch aus "Preparation of Self-Supporting Large-Area Polycristalline Structures of CsI(Na) by Evaporation", W. Schubert, Siemens Forsch.- u. Entwickl.-Ber., Bd. 3 (1974), Nr. 2, Springer Verlag, 1974, bekannt. Dabei wird eine Aufdampfrate von 65 Gew.-% des eingesetzten Materials erreicht.

Die DE 198 52 326 A1 offenbart ein Verfahren, welches sich insbesondere zur Beschichtung eines Substrats mit GaBr dotierten Leuchtstoffen eignet. Dabei wird der Leuchtstoff in der Bedampfungskammer im Vakuum auf eine erwärmte Verdampfungsquelle gegeben, wo er sofort verdampft und sich auf dem Substrat abscheidet.

Die DE 44 29 013 A1 beschreibt eine Vorrichtung zum Bedampfen eines Substrats mit einer Röntgenmessvorrichtung zur Messung der Schichtdicke. Um eine möglichst gleichmäßige Schichtdicke zu erzielen, wird die Bedampfungsrate in Abhängigkeit des Messergebnisses der Schichtdickenmessung geregelt.

Aus der DE 24 35 629 A1 ist ein Verfahren zur Glättung der Oberfläche einer auf einem Substrat aufgebrachten LeuchtStoffschicht bekannt. Dabei wird die Oberfläche nach Art des Schmiedens mit Schmiedekörpern bearbeitet.

Die DE 28 32 141 A1 und die EP 0 331 019 A2 offenbaren Verfahren zur Herstellung von Strahlenwandlerschirmen, bei denen eine auf einem Substrat aufgebrachte Leuchtstoffschicht zur Erzielung einer gleichmäßigen Schichtdicke geschliffen und poliert wird. - Dabei werden zwar über die Leuchtstoffschicht hinausragende Unebenheiten beseitigt. Beim Schleifen und Polieren werden jedoch relativ langwellige Unebenheiten erzeugt. Außerdem werden beim Schleifen relativ große Schleifmittelkörner in die Leuchtstoffschicht eingearbeitet. Diese vermindern die optische Qualität der Leuchtstoffschicht.

Um diesem Nachteil entgegenzuwirken, ist es nach dem Stand der Technik auch versucht worden, beim Verdampfen die Leuchtstoffquelle in einem möglichst großen Abstand vom Substrat anzuordnen. Die auf diese Weise abgeschiedenen Leuchtstoffschichten sind in ihrer Schichtdicke relativ gleichmäßig. Es muss hier allerdings viel Material beim Verdampfen eingesetzt werden, da hier nur etwa 10 Gew. % des verdampften Materials auf dem Substrat abgeschieden werden.

Aufgabe der Erfindung ist es, die Nachteile nach dem Stand der Technik zu beseitigen. Es soll insbesondere ein Verfahren angegeben werden, mit.dem auf möglichst einfache Weise eine Leuchtstoffschicht mit einer möglichst gleichmäßigen Schichtdicke herstellbar ist.

Diese Aufgabe wird durch die Merkmale des Anspruchs 1 gelöst. Zweckmäßige Ausgestaltungen ergeben sich aus den Merkmalen der Ansprüche 2 bis 11.

Nach Maßgabe der Erfindung ist ein Verfahren zur Herstellung einer Leuchtstoffschicht mit folgenden Schritten vorgesehen:
a) Abscheiden des Leuchtstoffs aus der Dampfphase auf einem Substrat derart, dass der Abstand der Leuchtstoffquelle vom Substrat so gewählt wird, dass mindestens 30 Gew. % des eingesetzten Leuchtstoffs auf dem Substrat abgeschieden werden und
b) abrasiver Abtrag der Leuchtstoffschicht auf eine vorgegebene, gleichmäßige Schichtdicke mittels eines Poliermittels, wobei vor dem Schritt b) die Schichtdickenverteilung der abgeschiedenen Leuchtstoffschicht ortsaufgelöst gemessen und die entsprechenden Daten können gespeichert werden.

Indem mindestens 30 Gew. % des eingesetzten Leuchtstoffs auf dem Substrat abgeschieden werden, wird die Wirtschaftlichkeit des Verfahrens erhöht. Eine gleichmäßige Schichtdicke kann dann durch einen anschließenden abrasiven Abtrag der Leuchtstoffschicht mit einem Poliermittel erzielt werden.

Zweckmäßigerweise wird das Substrat beim Schritt a) rotiert, wie z.B. beschrieben in W. Schubert, "Preparation of self-supporting large areas polycrystalline structures of CsI (Na) by evaporation" Siemens Forsch. u. Entwickl.-Ber. Bd.3 (1974) Nr.2 Seiten 100-102. Als Poliermittel wird vorteilhafterweise ein aus Kunststoff hergestellter Schwamm oder Filz verwendet. In dem Schwamm oder Filz kann pulverförmiger Leuchtstoff aufgenommen sein. Dabei handelt es sich zweckmäßigerweise um denselben Leuchtstoff, welcher auf dem Substrat abgeschieden worden ist. Als Leuchtstoff kommen hier insbesondere dotierte Alkalihalogenide, wie z.B. CsI:Na, CsI:Tl oder CsBr:Eu in Betracht. Durch die Aufnahme des pulverförmigen Leuchtstoffs im Schwamm oder Filz wird beim abrasiven Abtrag erreicht, dass in der Leuchtstoffschicht befindliche Risse mit dem pulverförmigen Leuchtstoff ausgefüllt werden. Es wird eine Glättung der Leuchtstoffschicht erzielt, wie z.B. beschrieben in DE 2 832 141 A1 oder EP-A-0 331 019.

Der abrasive Abtrag kann mittels einer nichtwässrigen Flüssigkeit, vorzugsweise Ethanol, Silikonöl oder Cyclohexan, durchgeführt werden.

Der Flüssigkeit können Korund- oder Diamantpartikel zugesetzt sein. Damit kann die Geschwindigkeit des abrasiven Abtrags erhöht werden.

Zur Durchführung einer solchen ortsauflösenden Messung kann die auf der Oberfläche des Substrats abgeschiedene Leuchtstoffschicht mittels eines Tastkopfs einer CNC-Meßmaschine oder mit einem optischen Verfahren, wie z.B. der Schräglichtlaserinterferometrie, gemessen werden. Es kommt auch eine Messung der Schichtdicke mittels Röntgenabsorptionsmessung in Betracht. Auf das Poliermittel kann ein Anpressdruck aufgebracht werden, dessen Größe umgekehrt proportional zur gemessenen Schichtdicke ist. D.h. der Anpressdruck wird auf das Poliermittel dort erhöht, wo die Schichtdicke groß ist. Ferner kann die Relativgeschwindigkeit des Substrats zum Poliermittel umgekehrt proportional zur gemessenen Schichtdicke sein. D.h. die Rotations- bzw. Umfangsgeschwindigkeit des Substrats ist an den Stellen besonders hoch, wo die gemessene Schichtdicke gering ist; sie ist dort gering, wo die gemessene Schichtdicke hoch ist. Das vorbeschriebene Verfahren zum abrasiven Abtrag wird zweckmäßigerweise computergestützt und unter Verwendung der gemessenen Daten durchgeführt. Dabei kann das Poliermittel z.B. radial über das rotierende Substrat bewegt werden.

Nachfolgend wird ein Ausführungsbeispiel des erfindungsgemäßen Verfahrens anhand der Zeichnung näher erläutert. Es zeigen:
- Fig. 1: eine rasterelektronenmikroskopische Aufnahme einer Inhomogenität in einer Leuchtstoffschicht,
- Fig. 2: eine rasterelektronenmikroskopische Aufnahme einer Bruchkante einer Leuchtstoffschicht durch eine Inhomogenität und
- Fig. 3: eine rasterelektronenmikroskopische Aufnahme auf die Oberfläche einer Leuchtstoffschicht.

Zur Herstellung einer Leuchtstoffschicht für einen Strahlenwandlerschirm wird ein z.B. aus einer ebenen Aluminiumscheibe hergestelltes Substrat in eine an sich bekannte Bedampfungsanlage eingebracht. Eine solche Bedampfungsanlage ist z.B. aus der DE 195 16 450 C1 bekannt, deren Offenbarungsgehalt hiermit einbezogen wird. Die Temperatur des Substrats wird so eingestellt, dass der Sättigungsdampfdruck über der auf dem Substrat kondensierenden Leuchtstoffschicht kleiner ist als das beim Bedampfen herrschende Vakuum. Es wird eine Leuchtstoffschicht mit einer Dicke von etwa 500 µm aufgedampft. Dabei wird der Abstand zwischen der Quelle des zu verdampfenden Leuchtstoffs und dem Substrat so gewählt, dass mindestens 30 Gew. %, vorzugsweise 50 Gew. %, des verdampften Leuchtstoffs sich auf dem Substrat niederschlagen.

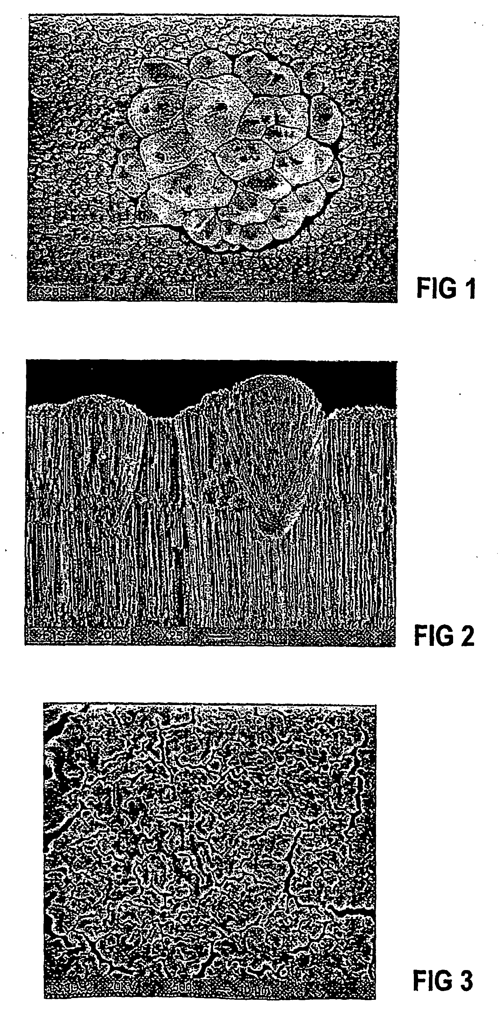

Die aufgedampfte Leuchtstoffschicht weist insbesondere die in Fig.1 und 2 gezeigten punktförmigen Inhomogenitäten auf, welche durch Riesenkornwachstum verursacht werden. Daneben kann auch eine durch das Bedampfen bedingte ungleichmäßige Schichtdickenverteilung auf dem Substrat auftreten.

Zur Herstellung einer gleichmäßigen Schichtdicke wird die Leuchtstoffschicht mittels eines Poliermittels auf eine vorgegebene gleichmäßige Schichtdicke reduziert. Als Poliermittel wird zweckmäßigerweise ein Filz, vorzugsweise ein Kunststofffilz, oder ein mit Kunststoffborsten bestücktes Poliermittel verwendet. Das Polieren erfolgt nass, vorzugsweise mit einer nichtwässrigen Flüssigkeit, z.B. Ethanol, Silikonöl oder Cyclohexan. Der Flüssigkeit können Diamantpartikel zugesetzt sein. Um ggf. an der Oberfläche der Leuchtstoffschicht vorhandene Risse zu verfüllen, können im Poliermittel Leuchtstoffpartikel aufgenommen sein. Dazu wird das Poliermittel zweckmäßigerweise in eine gesättigte wässrige Lösung des zu polierenden Leuchtstoffs gelegt und anschließend getrocknet.

Die Schichtdickenmessung der auf das Substrat aufgebrachten Leuchtstoffschicht erfolgt z.B. mit dem Tastkopf einer CNC-Meßmaschine, einem optischen Verfahren, wie z.B. der Schräglichtlaserinterferometrie, oder durch Röntgenabsorptionsmessungen.

Die bei der Schichtdickenmessung gewonnenen Daten werden einer nach dem zonalen Korrekturprinzip arbeitenden Poliervorrichtung zur Verfügung gestellt. Eine solche Poliervorrichtung wird z.B. von der Firma JenOptik AG unter der Bezeichnung "Feinkorrekturmaschine FK 300" angeboten. Mit einer solchen Poliervorrichtung wird an Stellen hoher Schichtdicke eine geringe Umfangsgeschwindigkeit des Substrats und gleichzeitig ein hoher Anpressdruck auf das Poliermittel eingestellt. Bei einer geringen Schichtdicke wird eine höhere Umfangsgeschwindigkeit und ein geringerer Anpressdruck eingestellt. Die Steuerung der Umfangsgeschwindigkeit, des Anpressdrucks und die radiale Position des Schleifmittels gegenüber dem rotierenden Substrat erfolgt automatisch, vorzugsweise computergestützt.

Mit dem erfindungsgemäßen Verfahren gelingt es, die Schichtdicke der Leuchtstoffschicht mit einer Abweichung von weniger als 2% einzustellen. Das entspricht im Falle einer z.B. aus CsBr:Eu hergestellten Leuchtstoffschicht einer maximalen Schichtdickenabweichung von weniger als 10µm.

Ein weiterer Vorteil des erfindungsgemäßen Verfahrens besteht darin, dass gleichzeitig an der Oberfläche der Leuchtstoffschicht befindliche Risse, wie sie z.B. in Fig. 3 gezeigt sind, durch die im Poliermittel aufgenommenen Leuchtstoffpartikel verschlossen werden.

## Patentansprüche

1. Verfahren zur Herstellung einer Leuchtstoffschicht mit folgenden Schritten:
a) Abscheiden des Leuchtstoffs aus der Dampfphase auf einem Substrat derart, dass mindestens 30 Gew.% des eingesetzten Leuchtstoffs auf dem Substrat abgeschieden werden und
b) abrasiver Abtrag der Leuchtstoffschicht auf eine vorgegebene gleichmäßige Schichtdicke mittels eines Poliermittels, wobei vor dem Schritt b) die Schichtdickenverteilung der abgeschiedenen Leuchtstoffschicht ortsaufgelöst gemessen und die entsprechenden Daten gespeichert werden.

2. Verfahren nach Anspruch 1, wobei das Substrat beim Schritt a) rotiert wird.

3. Verfahren nach einem der Ansprüche 1 oder 2, wobei als Poliermittel ein aus Kunststoff hergestellter Schwamm oder Filz verwendet wird.

4. Verfahren nach einem der vorhergehenden Ansprüche, wobei in dem Schwamm oder Filz pulverförmiger Leuchtstoff aufgenommen ist.

5. Verfahren nach einem der vorhergehenden Ansprüche, wobei der abrasive Abtrag mittels einer nichtwässrigen Flüssigkeit, vorzugsweise Ethanol, Silikonöl oder Cyclohexan, durchgeführt wird.

6. Verfahren nach einem der vorhergehenden Ansprüche, wobei der Flüssigkeit Korund- oder Diamantpartikel zugesetzt werden.

7. Verfahren nach einem der vorhergehenden Ansprüche, wobei auf das Poliermittel ein Anpressdruck aufgebracht wird, dessen Größe umgekehrt proportional zur gemessenen Schichtdicke ist.

8. Verfahren nach einem der vorhergehenden Ansprüche, wobei die Relativgeschwindigkeit des Substrats zum Poliermittel umgekehrt proportional zur gemessenen Schichtdicke ist.

9. Verfahren nach einem der vorhergehenden Ansprüche, wobei der abrasive Abtrag computergestützt unter Verwendung der gemessenen Daten durchgeführt wird.

10. Verfahren nach einem der vorhergehenden Ansprüche, wobei die Schichtdickenverteilung gemessen wird mit dem Tastkopf einer CNC-Meßmaschine, einem optischen Verfahren oder durch Röntgenabsorptionsmessungen.

11. Verfahren nach einem der vorhergehenden Ansprüche, wobei die Leuchtstoffschicht ein CsBr:Eu Leuchtstoffschicht ist mit einem maximalen Schichtdickenabweichung von weniger als 10 µm.

## Claims

1. A process for producing a phosphor layer, comprising the following steps:
a) vapour-phase deposition of the phosphor on a substrate in such a manner that at least 30% by weight of the phosphor used is deposited on the substrate, and
b) abrasive removal of the phosphor layer down to a predetermined, uniform layer thickness by means of a polishing means, wherein before step b) the layer thickness distribution of the phosphor layer deposited is measured by space resolved measurement, and the corresponding data are stored.

2. The process as claimed in claim 1, wherein the substrate is rotated during step a).

3. The process as claimed in any one of claims 1 or 2, wherein the polishing means used is a sponge or felt made of plastic.

4. The process as claimed in any one of the preceding claims, wherein pulverulent phosphor is incorporated in the sponge or felt.

5. The process as claimed in any one of the preceding claims, wherein the abrasive removal is carried out by means of a nonaqueous liquid, preferably ethanol, silicone fluid or cyclohexane.

6. The process as claimed in any one of the preceding claims, wherein corundum or diamond particles are added to the liquid.

7. The process as claimed in any one of the preceding claims, wherein a contact pressure the level of which is inversely proportional to the layer thickness measured is applied to the polishing means.

8. The process as claimed in any one of the preceding claims, wherein the relative velocity of the substrate with respect to the polishing means is inversely proportional to the layer thickness measured.

9. The process as claimed in any one of the preceding claims, wherein the abrasive removal is computer-aided using the measured data.

10. The process as claimed in any one of the preceding claims, wherein the layer thickness distribution is measured by means of the measuring head of a CNC measuring machine, by using an optical method, or by means of X-ray absorption measurements.

11. The process as claimed in any one of the preceding claims; wherein the phosphor layer is a CsBr:Eu phosphor layer with a maximum layer thickness deviation of less than 10 µm.

## Revendications

1. Procédé pour la fabrication d'une couche de luminophore, comprenant les étapes consistant à :
a) déposer le luminophore en phase vapeur sur un substrat de manière à ce qu'au moins 30 % en poids du luminophore utilisé soit déposé sur le substrat, et
b) enlever la couche de luminophore par abrasion jusqu'à une épaisseur prédéfinie, uniforme de la couche à l'aide d'un moyen à polir, la distribution de l'épaisseur de la couche déposée de luminophore étant mesurée avant l'étape b) par mesure à résolution spatiale, et les données correspondantes étant mémorisées.

2. Procédé selon la revendication 1, **caractérisé en ce que** ledit substrat est tourné pendant l'étape a).

3. Procédé selon l'une quelconque des revendications 1 ou 2, **caractérisé en ce que** ledit moyen à polir utilisé est un feutre ou une éponge de matière plastique.

4. Procédé selon l'une quelconque des revendications précédentes, **caractérisé en ce que** du luminophore pulvérulent est incorporé à l'éponge ou au feutre.

5. Procédé selon l'une quelconque des revendications précédentes, **caractérisé en ce que** l'étape consistant à enlever par abrasion s'effectue à l'aide d'un liquide non aqueux, de préférence l'éthanol, l'huile de silicone ou le cyclohexane.

6. Procédé selon l'une quelconque des revendications précédentes, **caractérisé en ce que** des particules de corindon ou de diamant sont ajoutées au liquide.

7. Procédé selon l'une quelconque des revendications précédentes, **caractérisé en ce qu'**une pression de contact dont la grandeur est inversement proportionnelle à l'épaisseur mesurée de la couche est appliquée au moyen à polir.

8. Procédé selon l'une quelconque des revendications précédentes, **caractérisé en ce que** la vitesse relative du substrat par rapport au moyen à polir est inversement proportionnelle à l'épaisseur mesurée de la couche.

9. Procédé selon l'une quelconque des revendications précédentes, **caractérisé en ce que** l'étape consistant à enlever par abrasion est assistée par ordinateur en utilisant les données mesurées.

10. Procédé selon l'une quelconque des revendications précédentes, **caractérisé en ce que** la distribution de l'épaisseur de la couche est mesurée à l'aide de la tête de mesure d'une machine de mesure à commande numérique par calculateur, par l'application d'un procédé optique, ou à l'aide de mesures par absorption des rayons X.

11. Procédé selon l'une quelconque des revendications précédentes, **caractérisé en ce que** ladite couche de luminophore est une couche de luminophore à base de CsBr:Eu présentant une déviation maximale de l'épaisseur de la couche inférieure à 10 µm.
